# EUROPEAN PATENT APPLICATION

(11) **EP 4 813 720 A1**
(43) Date of publication of application: **30.09.2026**
(21) Application number: 25166104.7
(22) Date of filing: 25.03.2025
(51) Int. Cl.: B60L 3/00, B60L 3/04, G01R 31/00, G01R 31/12, G01R 31/52

(54) **ELECTRICAL ARC FLASH EARLY DETECTION METHOD**

(71) Applicant: ABB E-mobility B.V., 2629 JG Delft (NL)
(72) Inventor: KOOLEN, Gertjan, 5622 CV Eindhoven (NL); VAN-DER-HEIJDEN, Jim, 5615 LD Eindhoven (NL)
(74) Representative: Zimmermann & Partner Patentanwälte mbB

(57) **Abstract**

A system is disclosed for detecting discharges in an electric equipment, the system comprising a first metallic conductor and a second metallic conductor which are spaced apart from each other and being configured for having an electric potential between each other. The system further comprises a third metallic conductor, placed between the first and second conductor. A galvanic connection electrically connects the third conductor with the first conductor through a resistor. The system further comprises a detection unit for detecting a current flow through the galvanic connection caused by a discharge through the gap between the second and third conductors.

## Description

### FIELD OF INVENTION

The present invention relates to the detection of discharges in an electric equipment, in particular in a high current electrical system such as an electric vehicle supply equipment, EVSE used for charging electric vehicle batteries.

### BACKGROUND OF INVENTION

Direct current (DC) chargers have become established for the high-current charging of traction batteries with a high working voltage. One reason is that, especially for high-current charging, it is not economical to equip each individual vehicle with a high-power inverter. Such inverters become, with increasing power rating, expensive, large and heavy and need increased cooling. Therefore, AC chargers are currently limited to low charging powers such as, generally from a wall-box, 11 to 22 kW and in some cases up to around 45kW. This is usually insufficient for fast-charging batteries for trucks or other larger vehicles.

For fast charging of traction batteries for trucks, the MCS system (Megawatt Charging system) has been developed. With a new MCS plug specification, the MCS can allow a DC charging power of up to 3.75 MW. It can be operated with a voltage of up to 1250 V at a maximum charging current of 3000 A, for example.

MCS charging devices are designed to charge large accumulators, such as those used in trucks, buses or, in the future, possibly aircraft in order to ensure short charging time and hence short possible standing time of a vehicle.

These large charging powers impose a number of challenges. Repeated charging processes and battery changes put a strain on the metallic connections carrying the charging current. For example, an insufficient metallic connection to the cables of the charging plug may cause transition resistances between the cable connection and the conductors to heat up due to a drop in power caused by contact resistances.

The overheating in the area of the junction (possibly also at other points) can now lead to the development of smoke gases. These smoke gases may reduce the dielectric strength of the gas (typically ambient atmosphere) surrounding the high-voltage components.

This example illustrates that in unfavorable situations, an electric arc could be triggered between high-voltage components such as conductors carrying the charging current in an EVSE. An uncontrolled electrical discharge or arc can cause serious damage. There is therefore a need for a reliable method of detecting potential discharges at an early stage and shutting down the system in good time.

Current solutions include temperature sensors near the conductors. However, this only detects the possible sources of interference where a sensor is located. Other fault locations from which smoke would develop could then only be detected once a dielectric discharge has occurred. Equipping all possible locations within the charging unit from which smoke could emanate with sensors would, however, be very impractical. Current solutions may also include optical or radiation sensors that detect smoke particles in the air. However, those methods are more expensive and have a lifetime that is intrinsically limited and therefore may not be practical in certain products.

It is therefore an object of the disclosure to provide an improved, reliable and economical detection mechanism which is capable of detecting the risk of a potential arc (dielectric discharge) within the electrical equipment.

### SUMMARY OF INVENTION

In order to address the foregoing and other potential problems, embodiments of the present disclosure propose the following:
In a first aspect of the present application, a system for detecting discharges in an electric equipment is disclosed. The system comprises a first metallic conductor and a second metallic conductor. The conductors are spaced apart from each other and are configured for having an electric potential between each other. The system further comprises a third metallic conductor that may be placed between the first and second conductor. The system further comprises a galvanic connection electrically connecting the third conductor with the first conductor. This galvanic connection can be provided through a current limiter (e.g. a resistor) and a detection unit for detecting a current flow through the galvanic connection, in particular through the current limiter, caused by a discharge through the gap between the second and third conductors.

In a second aspect, an electric vehicle supply equipment (EVSE) is disclosed. The supply equipment comprising a system as described herein.

In a third aspect, a method for operating a system for detecting discharges in an electric equipment as described herein is disclosed. The method may operate said system and comprises: detecting a current flow through a galvanic connection (e.g., current limiter) caused by a discharge through a gap between a second and a third conductor; and generating a dielectric breakdown signal when a discharge is detected.

### BRIEF DESCRIPTION OF DRAWINGS

Embodiments of the present disclosure will be presented in the sense of examples and their advantages are explained in greater detail below, with reference to the accompanying drawings, wherein:
FIG. 1 shows an illustration of the current situation;
FIG. 2 shows an illustration of an embodiment according to the application; and
FIG. 3 shows another embodiment according to the application.

### DETAILED DESCRIPTION OF EMBODIMENTS

Hereinafter, illustrative embodiments will be described. It should be understood, these embodiments are given merely for the skilled in the art to better understand and further practice the present disclosure, but not for limiting the scope of the present disclosure. Furthermore, features illustrated or described as part of one embodiment may be used with another embodiment to yield still a further embodiment. Also, in the interest of clarity, not all features of an actual implementation are described in this specification.

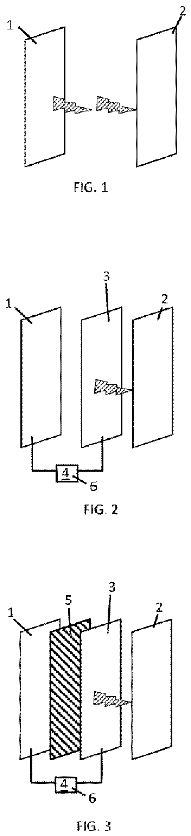

Fig. 1 schematically shows the conditions as previously known from the prior art charging system. Two current-carrying conductors are arranged at a distance from each other. The conductors 1 and 2, are usually mounted in a housing (not shown), which may be cooled and/or vented or airtight. The housing is filled with a dielectric gas such as ambient atmosphere. In a non-limiting example, the conductors belong to an EVSE for DC charging of a vehicle.

The conductors 1 and 2 may form a galvanic connection to respective phases of a charging cable (not shown). The galvanic connection can be designed as a screw connection, press connection, soldered connection or similar. These galvanic connections may be the source of heat during operation. Conductors 1 and 2 carry a high DC voltage, e.g., during a vehicle charging process. The high-voltage potential between them may cause, under certain unfavorable conditions, a discharge (indicated by the symbolized flash) to occur between the two conductors.

Fig. 2 shows a system according to the present disclosure, for detecting discharges in an electric equipment. The system comprises a first metallic conductor 1 and a second metallic conductor 2. These conductors are spaced apart from each other. Further they may be configured for having an electric potential between each other. Even if the main application may be for DC charging, the application may in principle also be suitable for AC chargers.

A third conductor 3 is arranged between the first and the second conductor 1, 2. The third conductor 3 may be arranged such that it is (dielectrically) closer to the second conductor 2 than to the first conductor 1. In particular, the third metallic conductor 3 may be placed and positioned, relative to the second conductor, with a gap having a lower dielectric breakdown voltage than the dielectric breakdown voltage between the first conductor 1 and the second conductor 2.

The third conductor 3 is electrically connected to the first conductor 1 via a galvanic connection (e.g. resistor 4). Due to the galvanic connection, the first and third conductors 1 and 3 have approximately the same electrical potential (before a breakdown).

A dielectric breakdown in the system may typically lead to an arc in a spark gap between the conductors (respective "capacitor plates") 2 and 3, as illustrated by an arc symbol in Fig. 2. This arc results in a current via the galvanic connection, e.g. through a current limiter such as a resistor 4.

This current flowing through the galvanic connection can be measured via a detection unit. The detection unit may be arranged in the system. The detection unit may be configured to detect a current flow through the galvanic connection caused by a discharge through the gap between the second and third conductors. The discharge may, in particular, be caused by an electrical potential between the second and third conductors 2, 3.

The detection strategy according to an embodiment may be described as being based on a (limited) current discharge detection (e.g., a partial discharge detection). Such limited current discharge detection is indicative of a imminent dielectric breakdown between the second and third conductors. In particular, the limited current discharge detection involves monitoring whether small discharges occur in insulating materials, in this case air. Such discharges can be an early indicator of an imminent insulation weakness or an imminent voltage flashover. These discharges may generate high-frequency signals or electromagnetic emissions and can be detected with a detection unit 6.

These discharges can be detected with the help the detection unit 6 - e.g. comprising a sensor such as a high-frequency current measuring device, acoustic emission sensor or electrical pulse sensor. The measured signals can then be used to assess, by the detection unit 6, whether a breakdown is likely.

Thus, the capacitor-like arrangement between conductors 2 and 3 uses the insight that an insulating capacitor (here: a capacitor formed by the second and third conductor 2 and 3) shows small, incomplete breakdowns (pre-discharges) when approaching its breakdown level, due to a changing insulating capability of the air between conductors 2 and 3 (similar to capacitor plates), which can be used as a warning signal.

In a clean environment, as can be assumed in the housing of a fault-free charging device, air has a sufficiently good dielectric strength. Still, remaining conductivity of the air may allow a tiny amount of charged particles (e.g. ions or electrons) to pass through the air at high electric fields (even below the breakdown) - this is known as leakage current. For example, dry air at direct current (DC) and under atmospheric pressure has a dielectric strength of approx. 3000V/mm. Factors such as humidity, impurities or dust or possible smoke development can substantially increase the conductivity of the atmosphere surrounding the conductors, which can degrade the dielectric strength and increase the leakage current. The system according to the embodiment of Fig. 2 allows detecting such degradation by causing and detecting a diagnostic dielectric breakdown between the conductors 2 and 3, well before a dielectric breakdown between other and possibly safety-relevant parts may occur. According to an embodiment, the system is configured for shutting down a high-voltage supply or disconnecting an electrical vehicle (EV) upon the detection unit 6 detecting of the dielectric breakdown between the conductors 2 and 3.

The embodiment shown in Fig. 3 corresponds in general to the embodiment in Fig. 2, and the description of Fig. 2 also applies to Fig. 3. In addition, in Fig. 3, an insulating element 5 is arranged between the first and the third conductors 1, 3. The insulating element can delay a breakdown between the first and the second conductors 1, 2. The threshold time for detecting an imminent breakdown between the third and second conductors 3, 2 is thus increased. In other words, the insulating element delays a breakdown to such an extent that there is a high probability that the breakdown between the second and third conductors would occur a good time before an arc between the first and the second connector could develop.

### DESCRIPTION OF FURTHER ASPECTS OF THE INVENTION

Next, further possible aspects of the invention are described. Each of these aspects may be combined with any other aspect of the present disclosure. While the following description includes reference signs, these are for illustration only, and any aspect may be combined with any other aspect, irrespective of other details shown in the Figures.

In an embodiment of the present application, a system for detecting discharges in an electric equipment is disclosed. The system comprises a first metallic conductor 1 and a second metallic conductor 2. These conductors 1 and 2 may be spaced apart from each other. (Fig. 2) Further the conductors 1 and 2 may be configured for having an electric potential between each other. The potential may be due to different DC voltages or different AC phases carried by the conductors 1 and 2.

Even though the invention is not limited to electrical vehicle charging, in an embodiment at least one of the conductors 1 and 2 may form a galvanic connection to a respective polarity of a charging cable. The galvanic connection can be a screw connection, press connection, soldered connection or similar.

The system further comprises a third metallic conductor 3 placed between the first and the second conductors 1, 2. In an aspect, the third metallic conductor 3 may be placed and positioned, relative to the second conductor, with a gap having a lower dielectric breakdown voltage than the dielectric breakdown voltage between the first conductor 1 and the second conductor 2. In particular, the lower breakdown voltage may be caused by a lower distance between the second conductors 2 and third metallic conductor 3, relative to the distance between the first conductor 1 and the second conductor 2.

According to an aspect, the arrangement of conductors 2 and 3 may be described as a spark-gap like arrangement, i.e. two metal surfaces with a fixed distance and a dielectric (e.g., ambient air) between them. According to an aspect, an insufficient dielectric strength and/or a dielectric breakdown may be determined by limited current discharge detection in this spark gap, i.e., by monitoring small, possibly incomplete discharges (pre-discharges) in the dielectric between the conductors 2 and 3. Such limited current discharges can be an early indicator of an imminent insulation weakness or an imminent voltage flashover (possibly before a complete breakdown occurs). These discharges generate high-frequency signals or electromagnetic emissions that can be detected with the detection unit 6.

According to an aspect, the detection unit 6 may comprise at least one sensor configured for measuring a (partial)-discharge event between the conductors 2 and 3 - e.g. such as high-frequency measuring devices, acoustic emission sensors or electrical pulse measurements. The measured signals can then be used to assess whether a breakdown is likely. In particular, the detection unit 6 may comprise a current sensor adapted for detecting a current flowing through the resistor 4, thereby indirectly measuring voltage changes in the conductor 3. Thereby, a discharge even can be detected by monitoring the current through resistor 4.

In a clean environment, as can be assumed in the housing of a fault-free charging device, air has a sufficiently good dielectric strength. Still, remaining conductivity of the air may allow a tiny amount of charged particles (e.g. ions or electrons) to pass through the air at high electric fields (even below the breakdown) - this is known as leakage current. For example, dry air at direct current (DC) and under atmospheric pressure has a dielectric strength of approx. 3000V/mm. Factors such as humidity, impurities or dust or possible smoke development can substantially increase the conductivity of the atmosphere surrounding the conductors, which can degrade the dielectric strength and increase the leakage current. The threshold for determining a (pre-) discharge is, in an aspect, set higher than an uncritical leakage current.

According to an aspect, the capacitor-like arrangement between conductors 2 and 3 uses the effect that an insulating capacitor shows small, incomplete breakdowns (pre-discharges) when approaching its breakdown level, due to a changing insulating capability of the air between conductors 2 and 3 (similar to capacitor plates), which can be used as a warning signal. According to another aspect, a dielectric breakdown between conductors 2 and 3 is detected.

According to an aspect, a galvanic connection may be arranged in the system and may be configured to electrically connect the third conductor 3 with the first conductor 1 through a current limiter 4, e.g. in form of a resistor or the like.. Due to the galvanic connection, the first and third conductors 1 and 3 have the same electrical potential before the breakdown. Thereby, it is ensured that before a dielectric breakdown between the conductors 1 and 2 occurs, a dielectric breakdown between conductor 2 and the diagnostic conductor 3, arranged (dielectrically) closer to conductor 2 than conductor 1, occurs. This dielectric breakdown may be detected before any harm in other parts of the apparatus is done.

According to an aspect, the aforementioned dielectric breakdowns may result in a current via the galvanic connection. The charge migration between the conductors (respective "capacitor plates") 2 and 3 discharges conductor 3. This migrated charge is compensated by a low but detectable current via the galvanic connection through current limiter 4 (e.g. a resistor)

According to an aspect, this current is measured via a detection unit 6. The detection unit 6 may be arranged in the system and may be for example integrated with the resistor 4. The detection unit 6 may be configured to detect a current flow through the galvanic connection caused by a discharge in the gap between the second and third conductors. The discharge may, in particular, be caused by an electrical potential between the second and third conductors 2, 3.

The detection unit 6 can be configured such that it sends a signal, wireless or wired, to a service station or maintenance personnel, when a discharge is detected.

The detection unit 6 can also be configured in such a way that it can adapt itself to different conditions in the housing. As mentioned, air is a good insulator and has, if it is dry air under normal conditions, a breakthrough voltage of 3kV/mm. But even in this case a few charges would be able to migrate between conductors 2 and 3 and generate a measurable current, even if this current were very low.

In humid air, as the charging stations can also be set up in public places, the charge migration could be stronger and trigger a false alarm, even though no smoke has been generated by a thermal incident.

Therefore, the detection unit 6 may be configured to regularly determine a limit value depending on the ambient conditions (humid air due to rain, very dry air in summer or in very cold winter, etc.), above which a possible breakdown is detected. This calibration can take place automatically at set times or when changes in the ambient conditions are detected. This may reduce the risk of false alarms.

In principle, the detection device can be designed to detect a current caused by the migration of charged particles, which can be triggered in particular by the smoke particles.

In a further aspect, an electrically insulating element may be disposed between the first conductor and the third conductor. The insulating element may be arranged in the system to improve the discharge behaviour. The additional insulating element may ensure that an initial (or first) discharge takes place between the third and second conductor.

This arrangement ensures that a breakdown between the first conductor and the second conductor occurs with a time delay. The breakdown path between the second and third conductors is thus given more time to react in advance, so that a dangerous breakdown between the first and second conductors can be prevented more safely.

In a further aspect, the electric equipment may be an electric vehicle supply equipment, EVSE. In particular the vehicle supply equipment may be suitable for loading accumulators in electric vehicles having a high demand on power like trucks or other electrically powered vehicles with high power demands.

In a further aspect, the detection unit 6 may be configured to generate a dielectric breakdown signal to deactivate a power supply when a current flow through the resistor is detected, the current flow indicating a discharge between the second and third conductors.

The detection unit 6 can also be designed in such a way that it reduces or switches off the electrical power supplied to the conductors 1 and/or 2 when a possible breakdown is detected.

Further, instead of being deactivated, the charging process or energy transfer can be terminated.

In yet a further embodiment, which may be combined with other embodiments, the third metallic conductor 3 may be a sheet-like. The third metallic conductor may be arranged parallel to the first conductor. Preferably the third conductor may have a smaller surface than the first conductor, the surface of the third conductor being preferably at most 50% of the surface of the first conductor. The surface of the third conductor may have an influence of the discharge behaviour and it may be, in limits, predeterminable, when the conductor arrangement, or better said, the detection unit 6, of conductors 2 and 3 determines a breakthrough or

In some embodiments the third conductor may have the form of a tip so that the form of the electric field between the third and second conductor can be influenced. For example, the shape of the third conductor can be used to create a tip effect, which can be used to shift the time at which a discharge occurs into an appropriate range (e.g., to have diagnostic value and/or to occur before other discharge in more critical parts of the apparatus occur).

In a further embodiment, which may be combined with other embodiments, the system may further comprise an enclosed compartment. The first, second and third conductors may be arranged within the closed compartment and protected against humidity. The compartment may be gas-tight.

In some embodiments, the housing may be ventilated to dissipate heat from the housing during the charging process. In the event that the detection unit 6 detects that a breakthrough between conductors 2 and 3 is imminent or has occurred, the housing can be ventilated using ventilation measures, such as a fan, in order to remove particle contaminated air (like smoke) and reduce the risk of a breakthrough.

The detection unit 6 may furthermore be configured to issue a message or an alarm to a maintenance department with service personnel in this case.

In yet a further embodiment, which may be combined with other embodiments, the first and second conductors are rated for a voltage difference of at least 800 V, preferably at least 1200 V between them.

In another embodiment, an electric vehicle supply equipment, EVSE, is disclosed that may comprise a system according to one of the preceding embodiments.

In a further embodiment, the EVSE according to another embodiment of the disclosure may comprise that the electrical arrangement or the system may be arranged in an enclosure of the EVSE.

In a further embodiment of the present disclosure, the EVSE according to other embodiments, may be configured for providing at least 1 MW of charging power to a charging connector. In particular, the EVSE may be suitable for charging batteries of trucks or other t

In a further embodiment, which may be combinable with other embodiments, a method for detecting discharges in an electric equipment is disclosed.

In the method for detecting discharges in an electric equipment, the respective electrical equipment may comprise: a first metallic conductor and a second metallic conductor which are spaced apart from each other hand having an electrical potential between each other, a third metallic conductor placed between the first and second conductor, and a galvanic connection electrically connecting the third conductor with the first conductor through a current limiter. The current limiter may be provided in form of a resistor.

The method for detecting discharges may comprise the steps of detecting a current flow through the galvanic connection caused by a discharge through the gap between the second and third conductors, and generating a dielectric breakdown signal when a discharge is detected.

The detection of said current flow through the galvanic connection, the resistor respectively, which may be an indication of a discharge, may be performed by a detection or detection unit 6. The detection unit 6 may also generate the dielectric breakdown signal.

In a further embodiment, which may be combined with other embodiments, the method may further comprise to deactivate a power supply or disconnection of an electrical vehicle (EV) when a discharge is detected. The deactivation may be performed by the detection unit 6. According to an embodiment, the system is configured for shutting down a high-voltage supply or disconnecting the electrical vehicle (EV) upon the detection unit 6 detecting of the dielectric breakdown between the conductors 2 and 3

In yet a further embodiment, which may be combinable with other embodiments, the method may comprise that the electric equipment is an electric vehicle supply equipment, EVSE.

To conclude, the application disclosed here facilitates the early detection of faults caused by smoke or conductive particles, possibly generated by heat, in high-current charging systems, particularly in MCS charging systems, in a simple manner. The presented system can be operated in parallel to other fault detection systems, for example temperature sensor controlled systems. The system presented can also be used as a simple, inexpensive stand-alone solution.

## Claims

1. A system for detecting discharges in an electric equipment, the system comprising:
a first metallic conductor (1) and a second metallic conductor (2) being spaced apart from each other and being configured for having an electric potential between each other;
a third metallic conductor (3), placed between the first and second conductor;
a galvanic connection electrically connecting the third conductor with the first conductor through a current limiter (4); and
a detection unit (6) for detecting a current flow through the galvanic connection caused by a discharge through a gap between the second and third metallic conductor (2, 3).

2. The system according to claim 1, wherein the electric equipment is an electric vehicle supply equipment, EVSE.

3. The system according to claim 1 or 2, wherein an electrically insulating element (5) is disposed between the first conductor (1) and the third conductor (3).

4. The system according to any one of the preceding claims, wherein the detection unit is configured to generate a dielectric breakdown signal to deactivate a power supply when the current flow is detected.

5. The system according to any one of the preceding claims, wherein the third metallic conductor (3) is a sheet-like and arranged parallel to the first conductor, and wherein preferably the third conductor has a smaller surface than the first conductor, a surface of the third conductor being preferably at most 50% of a surface of the first conductor.

6. The system according to any one of the preceding claims, further comprising an enclosed compartment, wherein the first, second and third conductors are arranged within the closed compartment and/or belong to a compartment wall of the closed compartment.

7. The system according to any one of the preceding claims, wherein the first and second conductors are rated for a voltage difference of at least 800 V, preferably at least 1200 V between them.

8. An electric vehicle supply equipment, EVSE, comprising a system according to one of the preceding claims.

9. The EVSE according to claim 8, wherein the electrical arrangement is arranged in an enclosure of the EVSE.

10. The EVSE according to claim 8 or 9, wherein the EVSE is configured for providing at least 1 MW of charging power to a charging connector.

11. A method for operating a system for detecting discharges in an electric equipment, wherein the system comprises:
a first metallic conductor and a second metallic conductor which are spaced apart from each other hand having an electrical potential between each other,
a third metallic conductor placed between the first and second conductor, and
a galvanic connection electrically connecting the third conductor with the first conductor through a resistor,
the method comprising:
- detecting a current flow through the galvanic connection caused by a discharge through the gap between the second and third conductors, and
- generating a dielectric breakdown signal when the current flow indicating the discharge is detected.

12. The method according to claim 11, further comprising:
- deactivating a power supply when a discharge is detected.

13. The method according to any of claims 11 to 12, wherein the electric equipment is an electric vehicle supply equipment, EVSE.

## Amended claims

### Amended claims in accordance with Rule 137(2) EPC.

1. A system for detecting discharges in an electric equipment, the system comprising:
a first metallic conductor (1) and a second metallic conductor (2) being spaced apart from each other and being configured for having an electric potential between each other;
a third metallic conductor (3), placed between the first and second conductor, wherein the third metallic conductor (3) is a sheet-like and arranged parallel to the first conductor;
a galvanic connection electrically connecting the third conductor with the first conductor through a current limiter (4); and
a detection unit (6) for detecting a current flow through the galvanic connection caused by a discharge through a gap between the second and third metallic conductor (2, 3).

2. The system according to claim 1, wherein the electric equipment is an electric vehicle supply equipment, EVSE.

3. The system according to claim 1 or 2, wherein an electrically insulating element (5) is disposed between the first conductor (1) and the third conductor (3).

4. The system according to any one of the preceding claims, wherein the detection unit (6) is configured to generate a dielectric breakdown signal to deactivate a power supply when the current flow is detected.

5. The system according to any one of the preceding claims, wherein the third conductor has a smaller surface than the first conductor, a surface of the third conductor being preferably at most 50% of a surface of the first conductor.

6. The system according to any one of the preceding claims, further comprising an enclosed compartment, wherein the first, second and third conductors (1,2,3) are arranged within the closed compartment and/or belong to a compartment wall of the closed compartment.

7. The system according to any one of the preceding claims, wherein the first and second conductors (1, 2, 3) are rated for a voltage difference of at least 800 V, preferably at least 1200 V between them.

8. An electric vehicle supply equipment, EVSE, comprising a system according to one of the preceding claims.

9. The EVSE according to claim 8, wherein the electrical arrangement is arranged in an enclosure of the EVSE.

10. The EVSE according to claim 8 or 9, wherein the EVSE is configured for providing at least 1 MW of charging power to a charging connector.

11. A method for operating a system for detecting discharges in an electric equipment, wherein the system comprises:
a first metallic conductor (1) and a second metallic conductor (2) which are spaced apart from each other hand having an electrical potential between each other,
a third metallic conductor (3) placed between the first and second conductor (1, 2)
wherein the third metallic conductor (3) is a sheet-like and arranged parallel to the first conductor, and
a galvanic connection electrically connecting the third conductor (3) with the first conductor (1) through a resistor (4),
the method comprising:
- detecting a current flow through the galvanic connection caused by a discharge through the gap between the second and third conductors, and
- generating a dielectric breakdown signal when the current flow indicating the discharge is detected.

12. The method according to claim 11, further comprising:
- deactivating a power supply when a discharge is detected.

13. The method according to any of claims 11 to 12, wherein the electric equipment is an electric vehicle supply equipment, EVSE.
